# EUROPEAN PATENT APPLICATION

(11) **EP 3 579 003 A1**
(43) Date of publication of application: **11.12.2019**
(21) Application number: 19175552.9
(22) Date of filing: 21.05.2019
(51) Int. Cl.: G01R 31/28

(54) **ARRANGEMENT AND METHOD FOR CONVEYING ELECTRONIC DEVICE IN TESTING SYSTEM**

(30) Priority: 04.06.2018 FI 20185507
(71) Applicant: JOT Automation Oy, 90590 Oulu (FI)
(72) Inventor: Puttonen, Mika, 90590 Oulu (FI)
(74) Representative: Kolster Oy Ab

(57) **Abstract**

An arrangement for conveying an electronic device in a testing system comprises a conveyer arrangement (20), which transfers electronic devices (100) to and from a plate (30), which moves with respect to the conveyer arrangement (20) and carry the electronic devices (100) to and from a testing chamber (202) within a testing cabinet (700), and a buffer structure (204) adjacent to the testing chamber (202) and comprising a plurality of compartments (206). The conveyer arrangement (20) conveys each of the electronic devices (100), which failed in a test performed in the testing chamber (202), to an empty compartment (206') of the buffer structure (204).

## Description

### Field

The invention relates to an arrangement and method for conveying an electronic device in a testing system.

### Background

Electronic devices, such as mobile phones, tablet computers, laptops and the like, may be beneficial to be tested in order to validate/verify their needed functionality. For example, when electronic devices are manufactured some or all of said devices may be tested in a radio frequency chamber in order to determine that the electronic devices are transmitting and/or receiving radio signals according to specifications. In another example, speaker of an electronic device may be tested in an audio chamber. Still, in another example, optical and mechanical features may also be tested.

When an electronic device fails the test, the failed device should be removed from the testing system and directed to a failure analysis or a repair process. In the current testing systems, a robotic arm grabs the failed electronic device and removes it from the test(s). However, the robotic arm requires space, increases complexity of the testing system, may be inaccurate in its movements, and to be accurate enough the robotic arm may, in turn, require constant adjustment and maintenance.

Hence, there is need to improve handling of the failed electronic devices.

### Brief description

The invention is defined by the independent claims. Embodiments are defined in the dependent claims.

### List of drawings

Example embodiments of the present invention are described below, by way of example only, with reference to the accompanying drawings, in which
Figure 1 illustrates an example of a conveyer arrangement;
Figure 2 illustrates an example of a situation where an electronic device has failed a test and it is moved towards a buffer structure;
Figure 3 illustrates an example of a situation where the electronic device is about to enter an empty compartment of the buffer structure;
Figure 4 illustrates an example of a situation where the electronic device is entering the empty compartment of the buffer structure;
Figure 5 illustrates an example of a situation where the electronic device has entered the empty compartment of the buffer structure, Figure 5 also includes a controller and sensors;
Figure 6 illustrates an example of how to take the compartment structure from the buffer structure;
Figure 7 illustrates an example of a testing cabinet;
Figure 8 illustrates an example of the controller comprising at least one processor and at least one memory; and
Figure 9 illustrates an example of a flow chart of a conveying method.

### Description of embodiments

The following embodiments are only examples. Although the specification may refer to "an" embodiment in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned. All combinations of the embodiments are considered possible if their combination does not lead to structural or logical contradiction.

In order to ensure high quality and to reduce failures of manufactured electronic devices, e.g. mobile phones, tablets, portable computers and/or their elements or electric circuits, various testing processes are carried out on a production line. A testing chamber 202 operates in production lines or as a stand-alone chamber 202 in a product development environment. The test may test various interfaces and/or functionalities of electronic devices 100, such as radio frequency communication, audio, optical and user interfaces to verify that the production process has assembled the device correctly. All functions of the test needed for the testing processes are typically automated.

As described above, the testing chamber 202 may be generalized as testing area, which means that the electronic device (in some cases the device may be non-electrical and the embodiments of the invention may also be applicable to non-electronic devices) is tested in the testing chamber 202. For example, the testing system may comprise one or more drawer-type testing chambers 202, wherein the electronic device is placed on the drawer when the drawer-type testing chamber 202 is open. For carrying out the test(s), the drawer is closed and thus the electronic device is brought into the testing chamber 202. After the test, the drawer may once again be opened, and the electronic device 100 may then, depending on the testing result, be conveyed to some other location on the testing system (e.g. similar testing chamber(s)), to some other part of the production process or to an empty compartment of the buffer structure (directly) adjacent to the testing chamber 202 and/or testing cabinet 700. So one or more tests in one or more testing chambers 202 may be performed for the same electronic device 100.

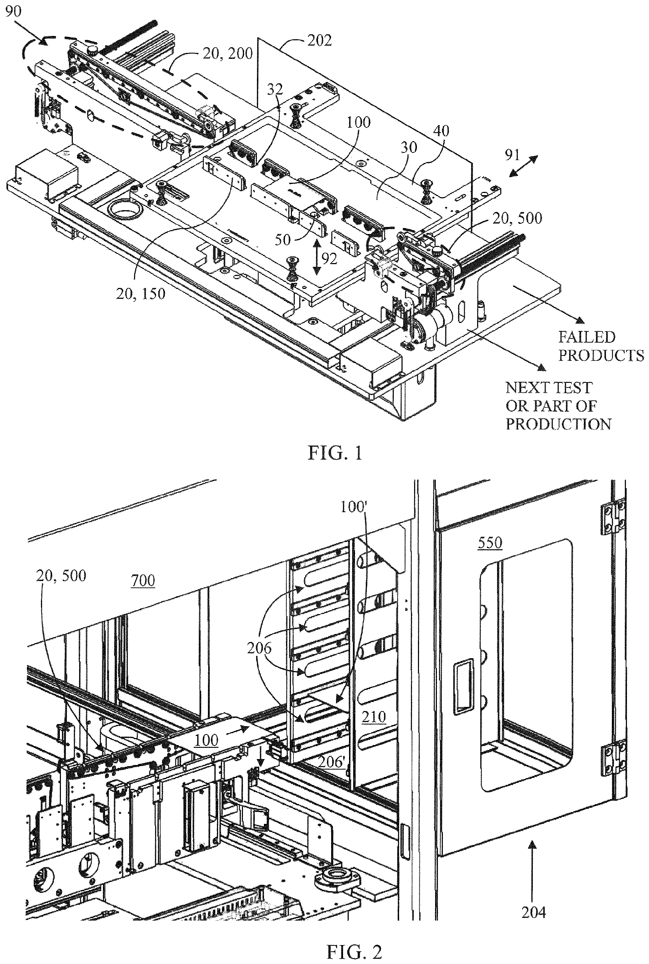

Accordingly, there is provided a conveyer arrangement 20 for conveying an electronic device 100 in a testing system as shown, for example, in Figures 1. The conveyer arrangement 20 includes the input system 200 and the output system 500.

The conveyer arrangement 20 does not necessarily require the described testing system, but may be utilized in other types of testing systems which are not necessarily explicitly disclosed. However, the described conveyer arrangement 20 can be used with a drawer-type testing system comprising one or more drawer-type testing chambers, for example.

Conveying here may mean that the electronic device 100 is moved from one position to another via plurality of stages.

The example sequence may show how the electronic device 100 is conveyed from an input section 200 (or simply first area) of the conveyer arrangement 20 via an exchange section 150 of the conveyer arrangement 20 to a testing area (e.g. testing chamber 202) of the testing system. Similarly, the electronic device 100 may be conveyed back from the testing area to an output section 500 (or simply second area) of the conveyer arrangement 20. In some embodiments, the input and output sections 200, 500 may be the same (e.g. conveyor arrangement 20 conveys the electronic device 100 to one direction when the electronic device is conveyed to the testing chamber 202 and to an opposite direction when the electronic device is conveyed from the testing chamber 202). In another embodiment, the input and output sections 200, 500 may be different (e.g. the conveyor arrangement 20 conveys the electronic device 100 only to one direction). Arrow 90 in Figure 1 may show the direction of the conveying according to one example. Arrow 92 may show the direction of the elevating and lowering of the conveyor arrangement 20 and/or the plate 30. The possible movement of the plate 30 (i.e. drawer) is shown with an arrow 91 in Figure 1. The movement may be perpendicular to the conveying direction by the conveyor arrangement 20. That is, arrows 91 and 90 may be perpendicular with each other.

According to an embodiment, a plate 30, which comprises at least one counterpart opening 32 for an exchange section 150 of the conveyor arrangement 20, may be separate from the conveyer arrangement 20.

The conveyer arrangement 20 may further comprise a frame 40 configured to support the plate 30. The plate 30 may be coupled with the frame 40. Thus, when the frame 40 moves (i.e. drawer-type testing chamber is closed or opened), the plate 30 may move with the frame 40. The frame 40 enables the use of more than one plate (i.e. electronic device-specific plates). For example, the plate 30 may be changed when the electronic device size or type changes.

Further, the conveyer arrangement 20 may comprise means for elevating the conveyor arrangement 20 such that the exchange section 150 passes through the at least one opening 32 of the plate 30 and extends above the plate 30. Then the conveyor arrangement 20 may convey the electronic device 100 from the input section 200 to the exchange section 150. Further, the conveyer arrangement 20 may be lowered such that the exchange section 150 moves through the at least one opening 32 of the plate 30 fully back below the plate 30. Then the plate 30 receives the electronic device 100 from the conveyor arrangement 20 in response to lowering the conveyor arrangement 20 through the at least one opening 32. The means for elevating and the means for lowering may comprise the same parts. The elevating and lowering may be performed using an electric motor or a pneumatic system.

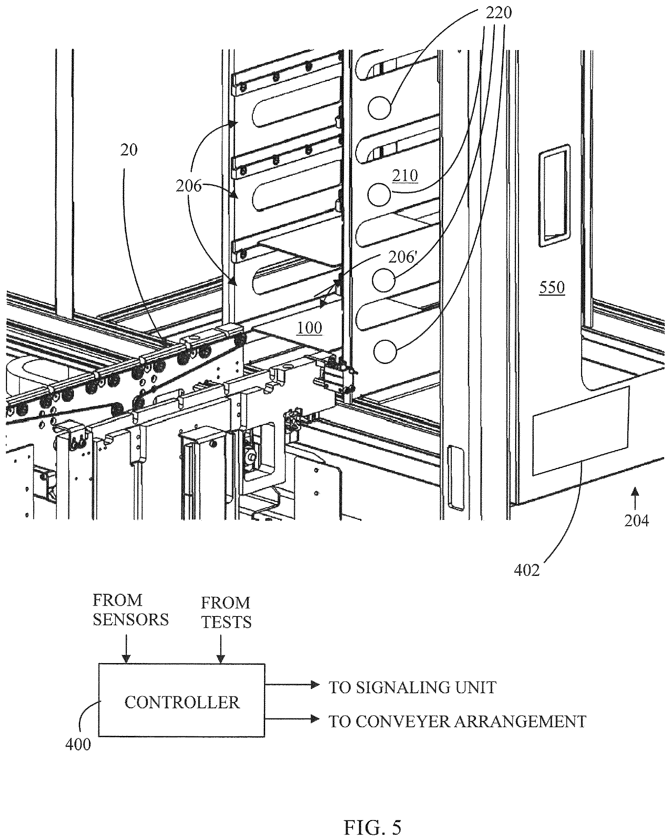

In an embodiment, the conveyer arrangement 20 may comprise means for stopping the conveying. The means for stopping may comprise, for example, a stopping member 50 shown in Figure 1. The stopping member 50 may be a part of the plate 30 or may be configured to elevate through the plate 30 via an opening of the plate 30 with the conveyer arrangement 20. The stopping member 50, according to an embodiment, may be a pneumatic stopping member configured to extend according to control message(s) from the controller 400 (see Figure 5). In more general terms, regardless whether for example a pneumatic or an electronic stopping member is used, the controller 400 may be configured to cause the stopping member 50 to extend in order to stop the conveying.

The plate 30 may further be configured to move with respect to the conveyor arrangement 20 and to carry the electronic device 100 to a testing chamber 202 of the testing system. The testing chamber 202 is illustrated with a shape of a parallelogram in Figure 1. After testing, the plate 30 may carry the electronic device 100 from a testing chamber 202 other parts of the testing system. The conveyer arrangement is described in more detail in Finnish patent application FI 20160282.

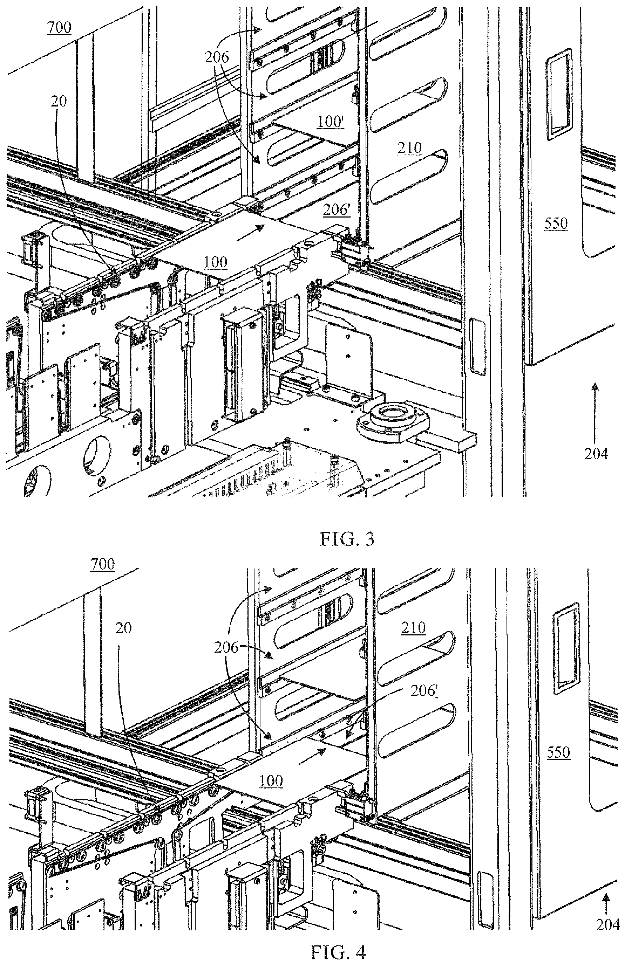

Figure 2 illustrates a situation where the electronic device 100 has failed the test and the conveyer arrangement 20 is transferring electronic device 100 to a buffer structure 204. The buffer structure 204 is adjacent to the testing cabinet 700. It may also be defined that the buffer structure 204 is directly adjacent to the testing cabinet 700. The buffer structure 204 is adjacent to the testing chamber 202. Also in this case it may be defined that the buffer structure 204 is directly adjacent to the testing chamber 202. The buffer structure 204 comprises a plurality of compartments 206. The compartments 206 may be made of a plurality of shelves. In an embodiment, the compartments 206 are one above another in a column or stack (as illustrated in Figure 2). In an embodiment, the compartments 206 may be side by side in a row. In an embodiment, a plurality of columns of the compartments 206 may be side by side thereby forming a matrix structure of compartments 206 (see Figure 3). The conveyer arrangement 20 conveys each of the electronic devices 100, which have failed in the test performed in the testing chamber 202, to an empty compartment 206' of the buffer structure 204. The conveyer arrangement 204 thus separates electronic devices 100 failed in the test from the electronic devices 100 which have passed the test. The same output section 500 of the conveyer arrangement 20, which moves an electric device that has passed the test further in the testing system or the production line, is used to convey an electric device that has failed the test to an empty compartment 206' of the buffer structure 204.

As seen in Figure 1, electronic devices 100 that have failed the test are moved away from the exchange section 150 and the testing and/or production with the same output section 500 as the electronic devices 100 that are moved to a next test or part of production. Note that when the output section is the same as the input section 200, the electronic devices 100 that have failed the test, may be returned in a direction opposite to a direction of movement towards the test.

In Figure 2, the electronic device 100 is horizontally moved forward towards the buffer structure 204. The conveyer arrangement 20 is also moved downwards in order to insert the electronic device 100 into the empty compartment 206'. In Figure 2, there is already one electronic device in the buffer structure 204.

The buffer structure 204 may be made of metal and/or plastic, for example. Some parts of the buffer structure 104 may be made of some other material, like glass. The shape of the buffer structure 204 may be that of a cube or a box.

In an embodiment, the buffer structure 204 comprises a compartment structure 210 which has the compartments 206, the compartment structure 210 being removable from the buffer structure 204. The compartment structure 210 may be made of metal and/or plastic, for example. Some parts of the compartment structure 210 may be made of some other material, like glass.

In an embodiment example of which is illustrated in Figures 3, the compartments 206 may be arranged in a two-dimensional configuration. In Figure 3, the compartments 206 are in two columns, each column having more than one compartment 204 one on or over another. The conveyer arrangement 204 may move correspondingly in a two-dimensional manner and insert each of the electronic devices 100, which have failed in the test performed in the testing chamber 202, to an empty compartment 206' of the buffer structure 204. The vertical movement may be achieved by moving the conveyer arrangement 20 vertically. The vertical movement may be based on the initial requirement that the conveyer arrangement can be elevated such that the exchange section 150 passes through the at least one opening 32 of the plate 30.

The horizontal movement can be achieved by moving the conveyer arrangement 20 horizontally which may also be an initial requirement for making the plate 30 and the conveyer arrangement 20 to meet each other properly.

In Figure 3, as compared to Figure 2, the conveyer arrangement 20 have been lowered to the level of the empty compartment 206' in Figure 3.

Figure 4 illustrates an example of a situation after Figures 2 and 3. The conveyer arrangement 20 is conveying the electronic device 100 into the empty compartment 206'.

Figure 5 illustrates an example of a situation after Figures 2, 3 and 4. The conveyer arrangement 20 has conveyed the electronic device 100 into the empty compartment 206'.

In an embodiment, the buffer structure 204 is structurally attached to the testing chamber 202.

In an embodiment, the compartments 206 may comprise shelves on which the conveyer arrangement 20 conveys each of the electronic devices 100, which failed in the test performed in the testing chamber 202.

In an embodiment an example of which is illustrated in Figure 5, the compartments 206 may have sensors 220 which may detect states of the compartments 206. A sensor 220 associated with a compartment 206 may detect whether the compartment 206 is empty or has an electronic device 100. The sensors 220 may comprise electrical sensors, magnetic sensors, pressure sensors or optical sensors, for example. The electrical sensor may detect a change in voltage or electrical current when the electronic device 100 is inserted into the compartment. The magnetic sensor may detect a magnetic change when the electronic device 100 is inserted into the compartment. The pressure sensor may detect a pressure caused by the electronic device. The optical sensor may detect a deviation in the light it detects when the electronic device 100 is inserted into the compartment. One example of a sensor 220 comprises an optical light source on one side of a compartment 206 and an optical detector on an opposite side of the compartment 206 such that the optical source illuminates the detector when the compartment is empty. When an electrical device 100 is in or comes deep enough inside the compartment 206 it blocks the light of the optical source from hitting the detector. The loss of light is detected by the detector and that is the signal representing the state of the compartment 206 that the compartment 206 has an electric device 100 therein. In an embodiment, any compartment 206 has at least one sensor 220.

In an embodiment, the arrangement comprises a controller 400 which may receive signals carrying information about the tests, and the states of the compartments 206 from the sensors 220. The controller 400 may control the conveyer arrangement 20 to convey each of the electronic devices 100, which have failed in the test performed in the testing chamber 202, to empty compartments 206' of the buffer structure 204 on the basis of the information. In this manner, the electrical devices 100 which pass the test(s), will not be conveyed to the buffer structure 204. But when an electrical device 100 fails the test(s) it will be conveyed to an empty compartment 206' if there is an empty compartment 206' according to the information. If no empty compartment exists, the conveyer arrangement 20 may be stopped by the controller 400.

In an embodiment an example of which is illustrated in Figure 5, the buffer structure 204 may comprise a signaling unit 402. The controller 400 may cause the signaling unit 402 to output an audio and/or visual alarm signal in response to the information that no compartment 206 of the buffer structure 204 is empty. The signaling unit 402 may comprise a lamp, a screen and/or a loudspeaker, for example.

In an embodiment, the sensors 220 may detect positions of the electronic devices 100 in the compartments 206. Each of the sensors may output a notification signal to the signaling unit 402 for outputting the alarm in a form of the audio and/or visual signal or the controller 400 if a position of any of the electronics devices 100 is different from a range of positions in the compartment 206 allowed by the sensor. If the notification signal is addressed to the controller 400, it may cause the signaling unit 402 to output the alarm in a form of the audio and/or visual signal.

In an embodiment, the controller 400 may cause the signaling unit 402 to output the audio and/or visual alarm signal in response to both an electronic device's 100 failure in the test and information that the buffer structure 204 has only one compartment 206 empty. In this manner, a user can be prompted while the last empty compartment 206 is filled with an electronic device.

In an embodiment an example of which is illustrated in Figure 2 to 7, the buffer structure may have a door 550 which can be opened, and through the open door 550 the compartment structure 210 is exchangeable to a new one. When the compartment structure 210 is full of electrical devices 100, the compartment structure 210 can be taken out of the buffer structure 204. A compartment structure 210 which has no electrical devices 100 may be inserted in the buffer structure 204. By opening the door 550, it is also possible to adjust the magazine width of the compartment structure 204 if that is required.

In an embodiment, a size of the compartment 206 is dimensioned for the electronic device 100 which is under test. The compartment structure 210 may have an identification component 212 which may be in connection with the controller 400 such that the controller 400 knows what kind of electronic devices 100 the compartment structure 210 is meant for. The identification component 212 may be a tag or the like, for example. If he size of the electronic device 100 changes, also the size of the compartment 206 may be changed. When the controller 400 receives information that an electronic device 100 that has different size than for which the compartment structure 210 is meant for, is going to be tested, the controller 400 informs the user about the contradiction through the signaling unit 402 which may include an interface such as a screen and a keyboard or a touch screen. The controller 400 may also stop the testing until the compartment structure 210 has been changed. The width of the compartment 206 may be from about 1 centimeter to a few centimeters, for example. However, the width may also be smaller or larger.

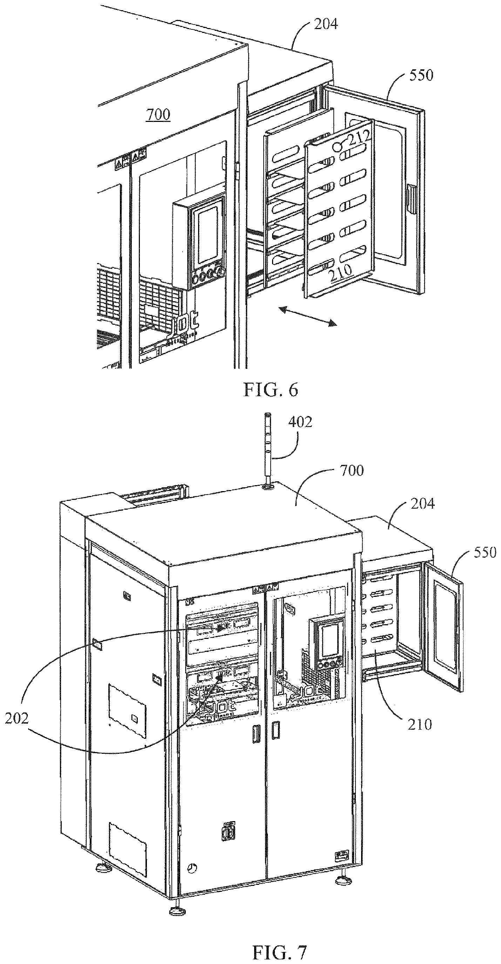

Figure 6 illustrates an example of how to take the compartment structure 210 from the buffer structure 204 and/or how to insert the compartment structure 210 into the buffer structure 204. The exchange of the compartment structure 210 may be performed by simply pulling the compartment structure 210 full of electrical devices 100 out of the buffer structure 204 when the door 550 is open and pushing a compartment structure 210 which is empty of the electrical devices 100 into the buffer structure 204.

Figure 7 illustrates an example of a testing cabinet. The testing system may comprise one or more testing cabinets. The testing cabinet includes the testing chamber 202 and the conveyer arrangement 20 (fully or partly). It can also be seen in Figure 7 that the signaling unit 402 may be on the top of the testing cabinet. The testing chambers 202 can also be seen behind the glass of a door of the cabinet 700.

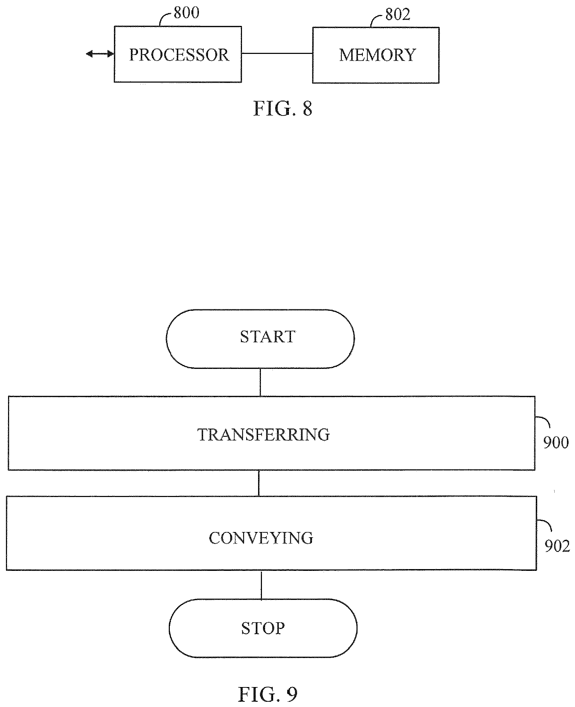

Figure 8 illustrates an example of the controller 400 comprising at least one processor and at least one memory. In an embodiment, the controller 400 may comprise at least one processor 800 and at least one memory 802. Their operation is based on a sequence of program commands of the computer program controlling the operation of the conveyer arrangement and/or the testing system. The computer program may be stored in the at least one memory 802.

By using the same conveyer arrangement 20 for conveying the electronic apparatus 100 to and from the test and conveying the electronic devices that failed the test to the buffer structure 204 adjacent to the testing cabinet 700 and/or the testing chamber 202 makes the system simple because no separate mechanical system is required for the transfer of the failed electronic devices.

This kind of approach to conveyer arrangement brings a benefit of reducing degrees of freedom of the movement in different stages of the process, but it still has the ability to move the electronic device 100 3-dimensionally (e.g. step by step). Thus, the proposed solution brings clear benefits compared with the use of robotic arm, such as vacuum gripper or mechanical gripper. Also, with mechanical gripper, for example, the force used to grab the electronic device 100 may cause damage to the electronic device 100. This may also be avoided using the proposed solution.

Figure 9 is a flow chart of the measurement method. In step 900, electronic devices 100 are conveyed to and from a plate 30 which moves with respect to the conveyer arrangement 20 and carries the electronic devices 100 to and from a testing chamber 202. In step 902, each of the electronic devices 100, failed in a test performed in the testing chamber 202 are conveyed, by a conveyer arrangement 20, to an empty compartment 206' of a buffer structure 204, which is adjacent to the testing chamber 202 and comprises a plurality of compartments 206.

The computer program may be distributed using a distribution medium which may be any medium readable by the controller. The medium may be a program storage medium, a memory, a software distribution package, or a compressed software package. In some cases, the distribution may be performed using at least one of the following: a near field communication signal, a short distance signal, and a telecommunications signal.

It will be obvious to a person skilled in the art that, as technology advances, the inventive concept can be implemented in various ways. The invention and its embodiments are not limited to the example embodiments described above but may vary within the scope of the claims.

## Claims

1. An arrangement for conveying an electronic device in a testing system, wherein the arrangement comprises:
a conveyer arrangement (20) configured to transfer electronic devices (100) to and from a plate (30) which is configured to move with respect to the conveyer arrangement (20) and carry the electronic devices (100) to and from a testing chamber (202) within a testing cabinet (700), **characterized in that** the arrangement additionally comprises:
a buffer structure (204) adjacent to the testing cabinet (700) and comprising a plurality of compartments (206), and said conveyer arrangement (20) is configured to convey each of the electronic devices (100), which failed in a test performed in the testing chamber (202), to an empty compartment (206') of the buffer structure (204).

2. The arrangement of claim 1, **characterized in that** the compartments (206) are arranged in a two-dimensional configuration, and the conveyer arrangement (20) is configured to move correspondingly in a two-dimensional manner and insert each of the electronic devices (100), which failed in the test performed in the testing chamber (202), to an empty compartment (206') of the buffer structure (204).

3. The arrangement of claim 1, **characterized in that** the buffer structure (204) is structurally attached to the testing cabinet (700).

4. The arrangement of claim 1, **characterized in that** the compartments (206) comprise shelves on which the conveyer arrangement (20) is configured to convey each of the electronic devices (100), which failed in a test performed in the testing chamber (202).

5. The arrangement of claim 1, **characterized in that** the compartments (206) have sensors (220) which are configured to detect states of the compartments (206), the states including information about each of the compartments (206) whether a compartment (206) is empty or has an electronic device (100).

6. The arrangement of claim 5, **characterized in that** the arrangement comprises a controller (400) which is configured to receive signals carrying information about the tests and the states of the compartments (206) from the sensors (220), and control the conveyer arrangement (20) to convey each of the electronic devices (100), which failed in the test performed in the testing chamber (202), to empty compartments (206') of the buffer structure (204) on the basis of the information.

7. The arrangement of claim 6, **characterized in that** the buffer structure (204) comprises a signaling unit (402), and the controller (400) is configured cause the signaling unit (402) to output an audio and/or visual alarm signal in response to the information that no compartment (206) of the buffer structure (204) is empty.

8. The arrangement of claim 7, **characterized in that** the sensors (220) are configured to detect positions of the electronic devices (100) in the compartments (206), and each of the sensors (220) with a detection that a position of the electronics device (100) is different from a range of positions in the compartment (206) allowed by the sensor (220) is configured to output an notification signal to the controller (400) which is configured to cause the signaling unit (402) to output an alarm in a form of the audio and/or visual signal.

9. The arrangement of claim 7, **characterized in that** the controller (400) is configured cause the signaling unit (402) to output the audio and/or visual alarm signal in response to both an electronic device's (100) failure in the test and information that the buffer structure (204) has only one compartment (206) empty.

10. The arrangement of claim 1, c**haracterized** in that the buffer structure (204) comprises a compartment structure (210) which has the compartments (206), the compartment structure (210) being removable from the buffer structure (204).

11. The arrangement of claim 10, **characterized in that** the buffer structure (204) has a door (420) through which the compartment structure (210) is exchangeable to a new one.

12. The arrangement of claim 1, **characterized in that** the arrangement comprises
one or more processors (800); and
one or more memories (802) including computer program code;
the one or more memories (802) and the computer program code configured to, with the one or more processors (800), cause the arrangement at least to:
control the conveyer arrangement (20) to convey each of the electronic devices (100), failed in a test performed in the testing chamber (202) to an empty compartment (206') of the buffer structure (204).

13. A method of conveying an electronic device in a testing system, wherein the arrangement comprises:
transferring (700), using a conveyer arrangement (20), electronic devices (100) to and from a plate (30) which is configured to move with respect to the conveyer arrangement (20) and carry the electronic devices (100) to and from a testing chamber (202) within a testing cabinet (700), c**haracterized** by:
conveying (702), by said conveyer arrangement (20), each of the electronic devices (100), failed in a test performed in the testing chamber (202) to an empty compartment (206') of a buffer structure (204), which is adjacent to the testing cabinet (700) and comprises a plurality of compartments (206).
